# FASCICULE DE BREVET EUROPEEN

(11) **EP 2 695 194 B1**
(45) Date de publication et mention de la délivrance du brevet: **04.05.2022**
(21) Numéro de dépôt: 12711889.1
(22) Date de dépôt: 03.04.2012
(51) Int. Cl.: H01L 21/02, H01L 33/38, H01L 33/24, H01L 33/18, H01L 21/336, H01L 29/775, B82Y 10/00, H01L 29/06, H01L 29/861, B82Y 40/00, B82Y 30/00

(54) **PROCEDE DE CROISSANCE SELECTIVE SANS CATALYSEUR D'UNE COUCHE SiNx SUR UNE STRUCTURE DE FIL SEMICONDUCTRICE GaN**
VERFAHREN FÜR KATALYSATORFREIES SELEKTIVES WACHSTUM EINER SiNx-SCHICHT AUF EINER GaN-HALBLEITERDRAHTSTRUKTUR
PROCESS FOR CATALYST-FREE SELECTIVE GROWTH OF A SiNx LAYER ON A GaN SEMICONDUCTOR WIRE STRUCTURE

(30) Priorité: 05.04.2011 FR 1152926
(43) Date de publication de la demande: 12.02.2014
(73) Titulaire: Commissariat à l'Énergie Atomique et aux Énergies Alternatives, 75015 Paris (FR); Université Grenoble Alpes, 38058 Grenoble Cedex 9 (FR)
(72) Inventeur: EYMERY, Joël, F-38360 Sassenage (FR); SALOMON, Damien, F-13008 Marseille (FR); CHEN, Xiaojun, Shanghai 200433 (CN); DURAND, Christophe, F-38950 Quaix-en-Chartreuse (FR)
(74) Mandataire: Ahner, Philippe
(86) Numéro de dépôt international: PCT/EP2012/056091
(87) Numéro de publication internationale: WO 2012/136665

(56) Documents cités:
- EP-A1- 1 744 323
- WO-A2-2010/062644
- FR-A1- 2 923 651
- US-A1- 2009 152 527
- US-A1- 2009 200 540
- US-A1- 2010 133 509
- WILDESON ISAAC ET AL: "III-nitride nanopyramid light emitting diodes grown by organometallic vapor phase epitaxy", JOURNAL OF APPLIED PHYSICS, AMERICAN INSTITUTE OF PHYSICS. NEW YORK, US, vol. 108, no. 4, 18 août 2010 (2010-08-18) , pages 44303-44303, XP012142689, ISSN: 0021-8979, DOI: 10.1063/1.3466998
- POOLE P J ET AL: "Selective epitaxy of semiconductor nanopyramids for nanophotonics", NANOTECHNOLOGY, IOP, BRISTOL, GB, vol. 21, no. 29, 23 juillet 2010 (2010-07-23), page 295302, XP020175110, ISSN: 0957-4484
- KOESTER R ET AL: "Self-assembled growth of catalyst-free GaN wires by metal-organic vapour phase epitaxy", NANOTECHNOLOGY, INSTITUTE OF PHYSICS PUBLISHING, GB, vol. 21, no. 1, 30 November 2009 (2009-11-30), pages 15602-1-15602-9, XP020168709, ISSN: 0957-4484

## Description

### DOMAINE TECHNIQUE

La présente invention concerne un procédé de croissance sélective sur une structure semiconductrice.

Elle s'applique notamment :
- en électronique, par exemple pour réaliser des transistors à base de nanofils (en anglais, *nanowires*) ou, plus exactement, de fils car ces derniers peuvent avoir des diamètres supérieurs à 10 nm,
- en opto-électronique pour obtenir une émission de lumière (l'invention permet le positionnement d'hétérostructures et le contrôle de ce positionnement, ainsi que la passivation « chimique » d'une zone de surface qui peut avoir des propriétés d'émission améliorée ou modifiée par rapport à une zone non passivée, par exemple dans le cas de fils de GaAs, d'InP ou de Si),
- à la détection de lumière, y compris dans le domaine photovoltaïque,
- à la réalisation de détecteurs/capteurs chimiques (l'invention permet de résoudre des problèmes de fonctionnalisation sélective), et
- en spintronique, par exemple en rajoutant des barrières entre des matériaux ferroélectriques ou en positionnant des hétérostructures dans un composant.

### ÉTAT DE LA TECHNIQUE ANTÉRIEURE

La croissance et le positionnement de couches minces de matériaux diélectriques, tels que des nitrures, des oxydes, des carbures par exemple, sont particulièrement importants pour réaliser les composants micro-électroniques et opto-électroniques : de telles couches minces permettent de créer des barrières, ou isolations, électriques qui sont par exemple capables d'isoler électriquement des parties de ces composants ou de permettre d'imposer un champ électrique sans transport de charge.

On trouve par exemple de telles couches dans le domaine des nanofils semiconducteurs, lorsqu'il s'agit d'isoler la grille d'un transistor MOS par rapport au canal de ce transistor. A ce sujet, on se reportera par exemple au document suivant :
[Thelander06] C. Thelander et al., Nanowire-based one-dimensional electronics, Materialstoday, Vol. 9, N° 10, 2006, pp.28-35.

On en trouve aussi dans des structures telles que les diodes électroluminescentes ou les photodétecteurs, lorsque l'on veut isoler électriquement les zones actives, par exemple pour réaliser un contact électrique afin d'injecter ou de collecter des porteurs (électrons, trous) dans un endroit spécifique de ces structures, en évitant des courts-circuits. A ce sujet, on consultera par exemple les documents suivants :
**[Hersee07]** Hersee et al., Catalyst-free growth of GaN nanoscale needles and application in InGaN/GaN visible LEDs, publication de demande de brevet US 2007/257264
**[Pederson08]** B. Pederson et al., Elevated LED and method of producing such, publication de demande de brevet WO 2008/079078
**[Hersee10]** Hersee, Solid-state microscope, publication de demande de brevet US 2010/033561
**[Hersee09]** S. D. Hersee et al., GaN nanowire light emitting diodes based on templated and scalable nanowire growth process, Electronics Letters, Vol. 45, N° 1, pp. 75-76, 2009.

Par ailleurs, ces couches minces de matériaux diélectriques peuvent permettre de « protéger » une partie d'une structure vis-à-vis d'une réaction chimique ou d'une adsorption, par exemple lorsque l'on veut contrôler la réaction ou le positionnement en un endroit de la structure.

Les techniques de croissance en phase gazeuse, telles que les techniques CVD, PECVD et ALD par exemple, sont bien adaptées pour faire croître des couches de matériaux diélectriques, tels que Si₃N₄, SiO₂, Al₂O₃ et HfO₂ par exemple. Mais il est toujours difficile de faire croître ces composés, de façon sélective et sans masquage, sur une surface, par exemple sur une partie d'un nanofil, sans recouvrir l'ensemble de la surface.

Pour résoudre ce problème, il est possible de faire croître une couche de matériau diélectrique sur toute la surface puis d'enlever localement la couche, par un procédé chimique, utilisant des solutions liquides ou gazeuses, ou un procédé physique, utilisant des faisceaux d'ions. Il est également possible d'ajouter localement, par masquage, une couche intermédiaire sur laquelle se fera aussi le dépôt mais qui pourra s'enlever facilement, afin d'obtenir une zone nue.

Ce type de gravure par décollement (en anglais, *lift-off)* peut par exemple être réalisé de façon chimique, en phase liquide. Dans le cas de nanofils semiconducteurs, des exemples d'un tel procédé peuvent être trouvés dans les documents suivants auxquels on se reportera :
**[Samuelson08]** Samuelson et al., LED with upstanding nanowire structure and method of producing such, publication de demande de brevet US 2008/149944;
**[Shin10]** Shin, Semiconductor device with vertical transistor and method for fabricating the same, publication de demande de brevet US 2010/237405.

En outre, pour former une structure sur un substrat à partir d'un semiconducteur composé tel que GaN, GaAs ou InAs par exemple, il est connu d'utiliser une couche d'un diélectrique tel que Si₃N₄ ou SiO₂ par exemple, pour faire croître sélectivement la structure. Alors, cette dernière ne pousse pas sur la couche de diélectrique mais dans des ouvertures qui permettent sa croissance sur le substrat. A ce sujet, on se reportera aux documents suivants :
**[Kitamura95]** S. Kitamura et al., Fabrication of GaN hexagonal pyramids on dot-patterned GaN/sapphire substrates via selective metalorganic vapor phase epitaxy, Jpn. J. Appl. Phys., Vol. 34 (1995) pp. L1184-L1186
**[Chen10]** X.J. Chen et al, Homoepitaxial growth of catalyst-free GaN wires on N-polar substrates, Appl. Phys. Lett., Vol. 97 (2010) 151909**.**

Avec la technique de MOCVD, c'est-à-dire la technique de dépôt chimique en phase vapeur aux organométalliques (en anglais, *metalorganic chemical vapor déposition),* il a été montré que l'on pouvait faire croître spontanément (c'est-à-dire d'une façon auto-organisée) des fils (en anglais, *wires),* sans catalyseur, par épitaxie sur des substrats de saphir d'orientation c ou sur du GaN, par exemple.

En effet, les catalyseurs peuvent être pénalisants pour les applications de tels fils : ils peuvent y introduire des contaminations chimiques.

Au sujet de cette technique de croissance spontanée des fils, on se reportera au document suivant :
**[Koester10]** R. Koester et al., Self-assembled growth of catalyst-free GaN wires by metal-organic vapour phase epitaxy, Nanotechnology, Vol. 21 (2010) 015602**.**

Cette technique est aussi utilisée pour obtenir d'autres structures telles que des bandes, des pyramides et des tubes par exemple, ou des hétérostructures comportant plusieurs matériaux.

En ce qui concerne les fils, des hétérostructures radiales et longitudinales peuvent aussi être réalisées. A ce sujet, on se reportera par exemple au document suivant :
**[Majumdar10]** Majumdar et al., Methods of fabricating nanostructures and nanowires and devices fabricated therefrom, publication de brevet US 7 834 264**.**

Pour intégrer des structures dans des composants, par exemple pour intégrer des fils verticaux ou horizontaux dans des transistors, des émetteurs de lumière, des détecteurs d'espèces chimiques (gaz ou ADN par exemple) ou des détecteurs de pH, il faut généralement ajouter des étapes technologiques complexes qui nécessitent notamment l'utilisation d'autres machines (d'où des transferts et les contaminations associées à ces derniers), de gravures et d'étapes d'alignement.

A ce sujet, on se reportera par exemple aux documents déjà cités [Thelander06] et [Hersee10].

Aussi les publications de demande de brevet US 2010/133509 et US 2009/152527 divulguent chacune une methode de formation de nanofils.

### EXPOSÉ DE L'INVENTION

La présente invention concerne un procédé de croissance sélective MOCVD telle que défini dans la revendication 1 et vise à apporter une solution simple au problème de la formation d'une couche de diélectrique, en permettant de contrôler (en anglais, *control)* la réalisation d'une telle couche qui couvre tout ou partie d'une structure obtenue par croissance cristalline, et ce sans ajouter d'étapes supplémentaires de lithographie/gravure ni de dépôts extérieurs, c'est-à-dire de dépôts effectués à l'extérieur de l'enceinte dans laquelle on forme la couche.

Cette couche de diélectrique peut servir de barrière à des croissances ultérieures et permettre ainsi des croissances sélectives, n'ayant pas lieu sur cette couche.

Elle constitue ce que l'on appelle parfois une « couche de passivation » quand on considère plus spécifiquement ses propriétés chimiques, notamment du point de vue des réactions qui ont lieu en surface (adsorption de molécules) et de la création de liaisons qui changent les propriétés électriques et optiques de surface.

Elle permet en outre d'obtenir des hétérostructures de semiconducteurs qui sont originales, notamment du point de vue de leurs contacts électriques, de l'application de champs électriques, ou de la réalisation de sites réactionnels, localisés sur des surfaces bien définies.

Selon divers aspects du procédé, objet de l'invention, pour créer une couche de diélectrique sur un support :
- on utilise une méthode de dépôt *in situ* dans une enceinte de croissance en phase gazeuse ;
- on utilise la sélectivité des mécanismes de croissance en phase gazeuse pour positionner cette couche sur le support ; ce positionnement est fait par rapport aux faces du support ou le long d'une direction de croissance de ce support ; et
- on contrôle les propriétés diélectriques de la couche en jouant sur les épaisseurs déposées et les conditions de croissance pour définir la stœchiométrie ; ces propriétés peuvent aussi être modifiées par des traitements ultérieurs, par exemple des recuits sous différents gaz (neutres ou réactifs).

Il convient aussi de noter que le procédé, objet de l'invention, est un procédé de croissance sélective sans catalyseur.

Selon l'invention, ce -procédé s'applique à la formation de couches diélectriques SiNx sur des nanofils faits en nitrure de gallium (GaN) en vue de recouvrir une partie de la longueur de ces nanofils.

Par rapport aux procédés classiques, un aspect essentiel du procédé, objet de l'invention, est de permettre de créer facilement et *in situ* une couche de matériau diélectrique sur un support, pendant la croissance de ce support et sans équipement supplémentaire.

Selon un mode de réalisation préféré du procédé, objet de l'invention, on choisit les conditions de croissance de la couche diélectrique de façon à agir sur la formation de la première structure semiconductrice.

De préférence, la couche diélectrique est choisie de façon que la deuxième structure semiconductrice se forme sur la première structure semiconductrice mais pas sur la couche diélectrique.

Selon un mode de réalisation particulier du procédé, objet de l'invention, on interrompt la croissance de la couche diélectrique, puis on la reprend.

Selon un mode de réalisation particulier de l'invention, la première structure semiconductrice est un fil qui s'étend verticalement à partir du substrat, on fait croître la couche diélectrique de façon qu'elle recouvre une partie inférieure du fil à partir du substrat, et l'on fait croître la deuxième structure semiconductrice seulement sur une partie supérieure du fil, qui n'est pas recouverte par la couche diélectrique.

Dans ce cas, on peut utiliser un substrat électriquement conducteur ou semiconducteur, former les première et deuxième structures semiconductrices de façon à constituer une diode, et former en outre un premier contact électriquement conducteur sur le substrat et un deuxième contact électriquement conducteur sur la deuxième structure semiconductrice.

Au lieu de cela, on peut utiliser un substrat électriquement conducteur ou semiconducteur, former les première et deuxième structures semiconductrices de façon à constituer une diode, et former en outre un premier contact électriquement conducteur sur le substrat et une couche en matériau électriquement conducteur et transparent qui recouvre de façon conforme la couche diélectrique et la deuxième structure semiconductrice.

En variante, on peut aussi séparer le fil du substrat après avoir formé la deuxième structure semiconductrice, puis placer le fil sur un autre substrat de façon que le fil s'étende horizontalement sur l'autre substrat.

Alors, on peut former en outre des contacts ohmiques ou électriquement conducteurs sur le fil, au niveau de la couche diélectrique et de la deuxième structure semiconductrice.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures lA à 1H sont des vues schématiques d'exemples de structures semiconductrices sur lesquelles on a respectivement déposé des couches diélectriques,
- les figures 2A et 2B illustrent schématiquement un exemple de mise en oeuvre de l'invention,
- la figure 3 montre les variations de la longueur d'un revêtement de multipuits quantiques, formé sur un fil semiconducteur, en fonction de la longueur du fil,
- les figures 4A et 4B sont des vues de dessus schématiques de structures qui sont obtenues par un procédé conforme à l'invention et résultent respectivement des structures représentées sur les figures 2A et 2B,
- la figure 5 est une vue en coupe schématique d'un dispositif obtenu conformément à l'invention, et
- la figure 6 illustre schématiquement une variante du dispositif de la figure 5.

### EXPOSÉ DÉTAILLÉ DE MODES DE RÉALISATION PARTICULIERS

Conformément à l'invention, on contrôle la croissance d'une couche diélectrique SiNx *in* si*tu* dans une enceinte adaptée à cette croissance.

La couche croît sélectivement sur une structure nanofil GaN et peut elle-même servir de masque à d'autres croissances, comme on le verra par la suite.

De plus, la croissance de la couche diélectrique SiNx peut s'intégrer directement à des étapes de réalisation d'un composant électronique.

En d'autres termes, lorsque l'on fabrique ce dernier dans un dispositif approprié, il n'est pas nécessaire de sortir le composant en cours de fabrication pour réaliser la couche : celle-ci peut être formée dans le même dispositif.

Selon un aspect de l'invention:
- dans une enceinte, on réalise la structure semiconductrice GaN sur laquelle on veut former une couche de diélectrique ;
- en même temps ou d'une façon décalée, on ajoute du silane, un précurseur du diélectrique SiNx, aux espèces chimiques servant à fabriquer la structure semiconductrice GaN ; le diélectrique SiNx, lorsqu'il est formé, peut aussi modifier les mécanismes de croissance de cette structure semiconductrice ; et
- on poursuit la mise en oeuvre du procédé avec d'autres espéces chimiques qui pourront éventuellement utiliser la sélectivité vis-à-vis de la couche de diélectrique qui vient d'être formée.

Les conditions de croissance selon l'invention permettent d'obtenir des fils semi-conducteurs de GaN sur lesquels on forme une couche de diélectrique de nitrure de silicium :
On utilise un bâti MOCVD 3x2", de type douchette, commercialisé par la société AIXTRON, avec des précurseurs triméthylgallium (TMG) à 0°C et ammoniac (NH₃) pour l'apport de Ga et N. Comme le décrit en détail le document [Koester10], un rapport de flux molaires dans la gamme 10-20 permet de favoriser la croissance des fils à environ 1000°C. Les flux molaires sont d'environ 60 sccm (centimètres cubes standard par minute) en TMG et 50 sccm en NH₃ et l'on utilise une pression d'environ 800 mbar (800 hPa).

L'obtention de la géométrie de type fil est réalisée, dès le début de la croissance du fil, par l'addition simultanée de silane. Ce silane est dilué dans de l'hydrogène à 100 ppm et l'on apporte un flux molaire d'environ 400 nmol par minute. Le flux de gaz porteur est majoritairement de l'azote ; avec des flux de 1000 sccm dans la ligne d'organométallique et dans la ligne NH₃, on obtient une vitesse de croissance des fils d'environ 130 µm par heure pour des diamètres de 400 nm à 1 µm.

Dans ces conditions, le fil va pousser sur un substrat de saphir, préalablement préparé conformément au document [Koester10], le long de l'axe c, et avec une couche de nitrure de silicium sur ses facettes latérales qui sont classiquement appelées « facettes de type plan m ».

Le flux de silane est arrêté après une certaine longueur de couverture de la couche de nitrure sur le fil, par exemple 5 µm. Le fil continue à pousser mais il ne comporte plus de couche de nitrure de silicium sur sa partie supérieure.

La croissance le long de l'axe c se poursuit alors que les plans m des facettes ne se développent quasiment plus. On a donc une très faible croissance latérale sur le sommet.

On a ainsi choisi des conditions de croissance de telle sorte que certaines faces de croissance de la structure se trouvent passivées par l'ajout du diélectrique et que la croissance cristalline de ces faces ralentisse ou cesse, tandis que d'autres faces continuent de croître.

Les détails de cette sélectivité dépendent directement des systèmes de matériaux utilisés, par exemple le système In-Ga-N, ainsi que des conditions expérimentales et des mécanismes mis en jeu.

A ce sujet, on se reportera par exemple au document [ChenlO] dans le cas du GaN obtenu par MOCVD.

L'épaisseur physique de la couche diélectrique SiNx, ainsi que l'épaisseur diélectrique équivalente, rapportée par exemple au dioxyde de silicium, sont définies notamment par :
- les concentrations dans les phases gazeuses ou dans les flux,
- le temps de dépôt de la couche diélectrique SiNx, et
- le temps et l'atmosphère de recuit de cette couche (par exemple sous hydrogène ou sous azote, ou sous un mélange de ces gaz).

A ce sujet, on se reportera à l'exemple d'étude physique qui est donné dans le document [Koester10].

A propos du recuit de la couche, on précise qu'une étape de recuit existe naturellement du fait d'une croissance à haute température sous azote. Et lorsque l'on fait croître des hétérostructures, la couche « subit » aussi toutes les étapes correspondantes qui peuvent être considérées comme un recuit plus éventuellement des apports de matière.

On est capable de vérifier l'existence et de déterminer la nature de la couche diélectrique, après la croissance de celle-ci, par exemple :
- par SIMS c'est-à-dire par spectrométrie de masse à ionisation secondaire (en anglais, *secondary ion mass spectroscopy),*
- par microscopie électronique analytique à haute résolution ou à perte d'énergie,
- par des mesures électriques telles que des mesures de barrières ou des mesures de tensions de claquage (en anglais, *breakdown voltages),* et
- par photoémission d'excitation X ou d'électrons.

Les figures lA à 1H sont des vues schématiques d'exemples de structures semiconductrices qui ont les références respectives 2a à 2h et sur lesquelles on a respectivement déposé des couches diélectriques 4a à 4h

Dans les exemples des figures lA à lC, selon l'invention les structures forment des fils, plus précisément des prismes à base polygonale, que l'on voit en coupe longitudinale.

Sur la figure lB, le SiNx est déposé sur une plus grande hauteur que sur la figure lA. Et, dans le cas de la figure lC, le dépôt du SiNx a été interrompu puis repris ; cela nécessite des fils de grande longueur, supérieure à 5 µm par exemple, avec des conditions de croissance telles que décrites ci-dessus et avec des vitesses de croissance supérieures à 50 µm par heure.

Cette limite, au-delà de laquelle le flux peut être interrompu, va dépendre directement des conditions générales de croissance des fils. Pour des flux beaucoup plus faibles en NH₃, où l'on a des taux de croissances plus faibles, on s'attend par exemple à des longueurs beaucoup plus faibles avant d'arrêter le flux de silane (voir un exemple de description de cette méthode dans le document [Pederson08]).

Dans une variante non représentée et non couverte par l'invention telle que revendiquée, les structures forment des tubes au lieu de former des fils.

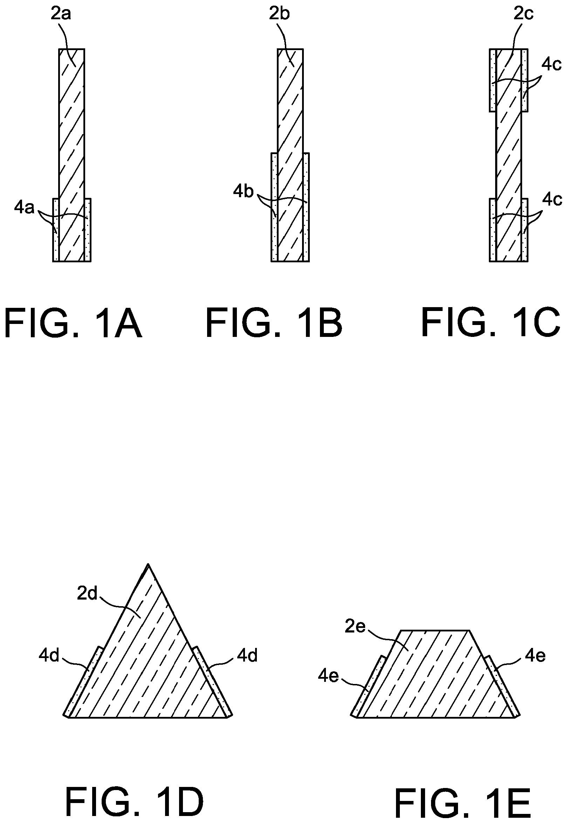

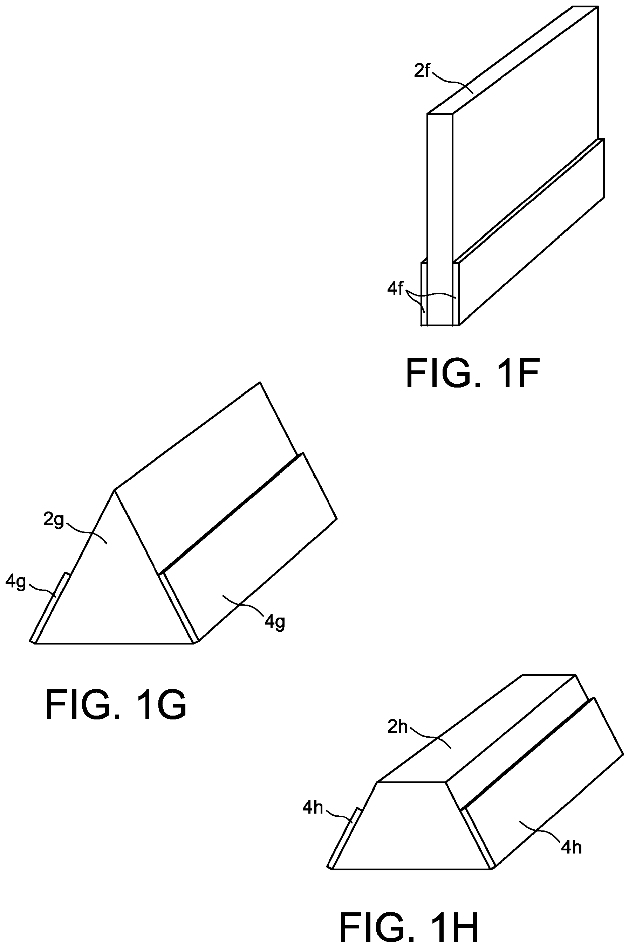

Dans les exemples des figures 1D et non couverts par l'invention telle que revendiquée, les structures forment respectivement une pyramide vue en coupe et une pyramide tronquée, vue en coupe.

Dans les exemples des figures IF à 1H, non couverts par l'invention telle que revendiquée, les structures forment respectivement un prisme à base rectangulaire, un prisme à base triangulaire et un prisme à base trapézoïdale, vus en perspective.

Toutefois, on peut aussi avoir des structures plus complexes, par exemple en utilisant la technique HVPE c'est-à-dire une épitaxie en phase vapeur par la méthode aux hydrures (en anglais, *hydride vapour phase epitaxy*). De telles structures ne sont pas couvertes par l'invention telle que revendiquée, et à

ce sujet, on se reportera au document suivant, en particulier à la figure 10 de celui-ci :
**[Chelda10]** O. Chelda-Gourmala et al., Complete HVPE experimental investigations : cartography of SAG GaN towards quasi-substrates or nanostructures, Journal of Crystal Growth, vol. 312, N°12-13 (2010), pp. 1889-1907**.**

Dans l'invention, on utilise un mode de croissance sélectif de la couche diélectrique SiNx . Pour ce faire, on utilise la technique de MOCVD. D' autres techniques pourraient être utilisées, par exemple la technique de MBE, mais de telles modifications ne sont pas couvertes par l'invention telle que revendiquée : à titre d'exemple, des effets de croissance sélective de GaN en utilisant un masque de titane ont été publiés. A ce sujet, on se reportera au document suivant :
**[Kishino08]** K. Kishino et al., Selective-area growth of GaN nanocolumns on titanium-mask-patterned silicon (111) substrates by RF-plasma-assisted molecular-beam epitaxy, Electronics Letters, vol. 44, No. 13 (2008), pp. 819-820**.**

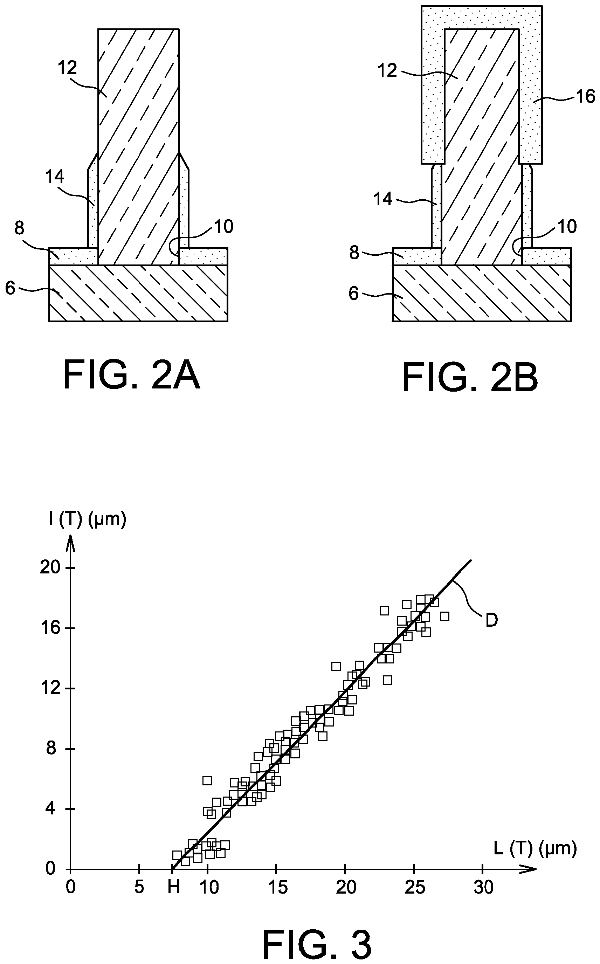

L'invention peut être utilisée dans le cas d'une structure semiconductrice qui est liée à un substrat lors de la croissance de cette structure (et de la couche diélectrique associée). On reviendra sur cette question lors de la description des figures 2A et 2B.

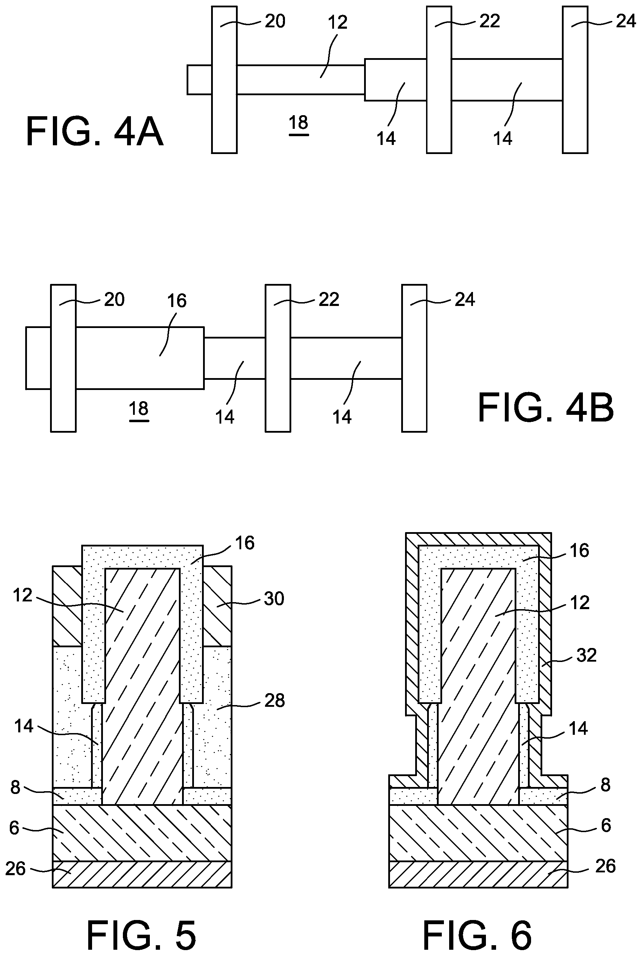

Mais elle peut aussi être utilisée dans le cas d'une structure semiconductrice qui est séparée du substrat sur lequel elle a été formée et qui est intégrée dans un autre dispositif. On reviendra sur cette question lors de la description des figures 4A et 4B.

Un exemple classique concerne les structures à base de nanofils, pour lesquelles on peut adopter des géométries tant horizontales que verticales.

L'invention est particulièrement intéressante pour fournir une solution au problème de la conception de composants électroniques ou opto-électroniques ou de capteurs, pour séparer facilement deux parties de tels composants ou de tels capteurs.

En particulier, elle est utilisable :
- pour séparer différentes structures ayant des dopages différents, par exemple des dopages de types N et P ou des dopages de types N+ et N, ou même pour séparer des structures non intentionnellement dopées (qui, il est vrai, ont toujours un dopage de type N ou P),
- ou pour protéger une zone vis-à-vis d'un milieu électrique ou chimique.

L'invention apporte aussi une solution au problème de la simplification de la réalisation de structures semiconductrices telles que celles qui sont représentées sur les figures 1A à 1C.

De plus, l'invention présente les avantages suivants :
- elle est facile à mettre en oeuvre, étant donné qu'elle utilise une croissance *in situ ;*
- elle permet la suppression d'étapes technologiques qui sont coûteuses ou consomment du temps ;
- elle constitue un procédé industriel qui est parfaitement intégrable dans les procédés classiques de la nano-électronique et de l'optoélectronique ;
- elle permet la création d'une passivation de surface qui améliore certaines propriétés physiques : cette passivation de surface conduit, entre autres, à la diminution d'états de surface, de charges et d'effets de recombinaisons non radiatives ;
- elle permet la croissance de fils semiconducteurs ;
- elle permet de simplifier les procédés de fabrication de certains composants électroniques ; et
- elle permet de former une couche diélectrique protectrice grâce à laquelle on peut effectuer un dopage local.

On décrit ci-après un exemple du procédé, objet de l'invention, permettant de fabriquer des couches d'un matériau diélectrique sur des premières structures semiconductrices ou supports, puis des deuxièmes structures semiconductrices sur les premières.

Les supports sont constitués de fils de GaN, obtenus par MOCVD, sans catalyseur, comme cela est décrit dans le document [Koesterl0] auquel on se reportera.

En ce qui concerne des variantes de cette technique MOCVD sans catalyseur, on se reportera au document suivant :
**[Hersee08]** Hersee et al., Pulsed growth of catalyst-free growth of GaN nanowires and application in group III nitride semiconductor bulk material, US2008/0036038**.**

Il existe aussi une autre variante qui joue sur les rapports des flux des gaz porteurs H₂ et N₂. A ce sujet, on se reportera au document suivant :
**[Bergbauer10]** W. Bergbauer et al., Continuousflux MOVPE growth of position-controlled N-face GaN nanorods and embedded InGaN quantum wells, Nanotechnology, vol. 21, N°30 (2010), article n°305201**.**

Dans l'exemple de réalisation de l'invention décrit, le procédé comprend trois étapes essentielles :
1. Dans un premier temps, chaque fil-support est réalisé en apportant, dans l'enceinte où l'on fabrique les structures semiconductrices, un précurseur constitué de silane (SiH₄) qui favorise la géométrie de type fil et induit un dopage de type N, mais qui crée aussi une couche diélectrique très fine de nitrure de silicium SiNₓ à la surface du fil. Ainsi cette couche latérale de SiNₓ croît-elle spontanément.
   La nature chimique de cette couche a été mesurée par SIMS. Son caractère diélectrique est déterminé grâce à des mesures tension-courant, jusqu'au claquage (en anglais, *breakdown)* de la barrière isolante constituée par cette couche diélectrique.
2. Le flux de silane est ensuite arrêté. Le support (fil) continue de croître ; le niveau de dopage de type N diminue dans la partie du fil qui est formée après l'interruption du flux de silane.
3. A la fin de la croissance du support, on fait croître, de façon radiale, un multipuits quantique (en anglais, *multiquantum well)* InGaN/GaN qui recouvre seulement la partie du support ne comportant pas de SiNₓ. Ainsi, l'autre structure semiconductrice, constituée par le multipuits quantique ou MQW, croît sélectivement sur le support.

A titre purement indicatif et nullement limitatif, le nombre de puits quantiques du MQW est égal à 5.

Par ailleurs, il a été remarqué qu'on peut contrôler, par la valeur du flux de silane la formation des nanostructures et qu'il existe un seuil pour ce flux de silane au-delà duquel le procédé de l'invention est plus efficace. Ce seuil peut être déterminé de la façon suivante : pour un réacteur donné et pour des conditions de croissance données, on trace la valeur du diamètre des nanofils en fonction de la valeur du flux de silane

Lorsque le flux augmente, le diamètre diminue rapidement pour se stabiliser à une valeur minimale ou pour réaugmenter lentement à partir d'une valeur de flux qui sera considérée comme la valeur seuil.

Il faut donc une quantité suffisante du flux de silane pour obtenir un effet notable de la limitation de la section des nanofils par la création de la couche diélectrique SiNx.

A titre d'exemple pour la réalisation de fils de GaN, un seuil d'environ 105 nmol/minute de silane permet d'obtenir des fils de diamètre inférieur à 400 nm (à une vitesse de croissance supérieure à 40 µm/heure), pour un rapport Ga/N d'environ 16 et pour des flux de TMG et de NH₃ respectivement égaux à 90 sccm et 75 sccm (régime standard de flux de précurseurs) où sccm signifie bien entendu cm³ standard par minute et TMG triméthylgallium.

Dans l'exemple ci-dessus, le silane a été envoyé dans l'enceinte en même temps que les flux gazeux servant à former les fils de GaN.

Les vues en coupe des figures 2A et 2B illustrent schématiquement l'exemple que l'on vient de donner dans les paragraphes 1 à 3 ci-dessus.

Sur la figure 2A, on voit un substrat 6. Ce dernier est recouvert d'une fine couche de masquage 8 en SiNₓ qui est pourvue de trous tels que le trou 10. Les supports tels que le semiconducteur 12 croissent verticalement au niveau de ces trous.

Dans une variante non représentée et ne pas couverte par l'invention telle que revendiquée, on n'utilise aucune couche de masquage : on fait croître les fils sur le substrat 6.

Dans l'exemple de la figure 2A, on a formé la couche de masquage 8 dans la même enceinte que celle dans laquelle on met en oeuvre le procédé.

Toutefois, dans une variante non représentée, cette couche 8 est formée sur le substrat 6 et pourvue de trous avant d'introduire ce substrat dans l'enceinte.

En revenant à la figure 2A, on voit la couche diélectrique 14 en SiNₓ qui croît sélectivement sur le fil vertical 12 : cette couche 14 recouvre une partie inférieure du fil 12 à partir du substrat.

Il convient de noter que ce fil pourrait être hétérogène, par exemple pour ce qui concerne le dopage ou la concentration le long de son axe de croissance.

La croissance de la couche diélectrique 14 peut être arrêtée au bout d'un certain temps de sorte que cette couche ne recouvre que partiellement le support, comme on le voit sur la figure 2A.

La figure 2B montre la croissance sélective d'une couche ou d'une multicouche 16, à savoir un multipuits quantique dans l'exemple considéré plus haut, sur la partie du fil 12 qui n'est pas recouverte par la couche diélectrique 14.

Cette couche ou multicouche 16 peut être de même nature que le substrat 6. Toutefois, dans certains cas, elle doit avoir un dopage différent du dopage du substrat, par exemple lorque l'on veut fabriquer une diode N/P d'une autre nature que le fil 12, ou même une hétérostructure.

A titre d'exemple, le substrat est en GaN (par exemple dopé N) (mais il pourrait également être, par exemple, en AlN, en Si (par exemple dopé N ou P) avec éventuellement une couche intermédiaire d'AlN, en ZnO (par exemple dopé N), ou en saphir) ; le fil est en GaN dopé N ou N+ ; la couche 14 est en Si₃N₄ et l'on forme une couche 16 en InGaN ; ou, au lieu de cette couche 16, on forme une multicouche InGaN/GaN ; puis on forme une couche de GaN dopé P sur cette couche ou cette multicouche ; on obtient ainsi une structure de diode électroluminescente.

Il convient de noter que le cas où il n'y a pas de croissance sélective, c'est-à-dire lorsque la couche ou multicouche 16 recouvre la couche diélectrique 14 voire la couche de masquage 8, est également intéressant. En effet, on conserve alors un découplage électrique entre le substrat 6 et cette couche ou multicouche 16.

A titre purement indicatif et nullement limitatif, on donne ci-après un exemple du procédé, objet de l'invention, permettant d'obtenir une structure du genre de celle qui est représentée sur la figure 2B :
On utilise un bâti MOCVD 3x2" de type douchette, commercialisé par la Société AIXTRON, avec des précurseurs triméthylgallium (TMG) à 0°C et ammoniac pour l'apport de Ga et N. On utilise, dans cet exemple d'application, une méthode de croissance auto-organisée des fils sur le substrat 6 de saphir, d'orientation c, comme le décrit en détail le document [Koester10]. Les étapes successives suivantes sont utilisées :
- Le substrat de saphir est recuit sous H₂ à 1040°C pendant 20 minutes, et nitruré avec NH₃ avec un flux de 2000 sccm pendant 30s. Cela a pour conséquence de nettoyer la surface, de la lisser et de former une très fine couche superficielle d'AlN qui améliore la qualité de l'épitaxie, notamment du point de vue du contrôle de la polarité du support 12 (voir le document [Chen10]).
- La couche 8, sur le substrat 6, est formée directement dans le réacteur. Pour ce faire, on injecte simultanément du silane SiH₄ (45 sccm dilué à 100 ppm dans H₂) et du NH₃ (4000 sccm). Finalement, la couche 8 est constituée par une couche d'environ 1,5 nm de AlN et de 2 nm de nitrure de silicium comme on l'a déterminé par réflectivité de rayons X.
- Les sites de nucléation du support 12 sont déterminés par une étape de nucléation de 10 s à 1000°C pendant laquelle on injecte 135 µmol par minute de TMG et 2,232 mmol par minute de NH₃ dans un gaz porteur constitué d'azote, avec un débit de 8000 sccm. Les nucléats du support 12 sont ainsi formés ; ils sont épitaxiés sur le substrat 6.
- La croissance du support 12 commence en utilisant conjointement TMG et NH₃, avec un rapport de flux molaires égal à 15 à environ 1000°C. Les flux molaires sont d'environ 60 sccm pour TMG et 50 sscm pour NH₃ et l'on utilise une pression d'environ 800 mbar (800 hPa).

L'addition simultanée de silane permet de favoriser la géométrie de type fil mais permet aussi de faire croître la couche de nitrure 14. Ce silane est dilué dans de l'hydrogène à 100 ppm et l'on apporte un flux molaire d'environ 400 nmol par minute de silane. Le flux de gaz porteur est majoritairement de l'azote. Pour des flux de 1000 sccm dans la ligne d'organométallique et dans la ligne NH₃, on obtient une vitesse de croissance des fils d'environ 130 µm par heure pour des diamètres de 400 nm à 1 µm.
- Au bout de 3 minutes de croissance (taille du fil d'environ 7,5 µm), on arrête le flux de SiH₄ et la croissance du support 12 se poursuit. Un temps d'environ 6 minutes supplémentaires peut conduire à une longueur du fil d'environ 22,5 µm, avec 15 µm du support 12 qui ne sont pas recouverts de la couche 14.
- On procède ensuite à la croissance de la couche 16, à savoir cinq puits quantiques InGaN/GaN dans l'exemple. Cette croissance a lieu simplement sur la partie du support 12 qui n'a pas la couche diélectrique 14. Un puits quantique d'InGaN, d'épaisseur 1 nm (temps de croissance d'environ 20 s), est déposé à 730°C sous flux de gaz porteur N₂ en utilisant le TMG, l'ammoniac et le précurseur triméthylindium (TMI).

La température est rapidement augmentée à 840°C pour faire croître une barrière de GaN d'environ 10 nm en utilisant un précurseur de triéthylgallium (TEG). La dernière barrière de GaN peut être dopée N ou P suivant les besoins du dispositif. On peut aussi ajouter des couches de blocage d'électrons (en anglais, *electron blocking layers*) en AlGaN pour améliorer les caractéristiques électriques, comme dans les structures de LED bidimensionelles classiques.

A titre d'exemple, par un procédé conforme à l'invention, on a fait croître des fils de GaN en présence d'un flux de silane pendant 300 secondes. On a ainsi obtenu des fils de même hauteur H, égale à 7,5 µm, recouverts d'une couche de matériau diélectrique, le nitrure de silicium.

On précise que l'on peut facilement faire varier cette hauteur en modifiant le temps de croissance ou la vitesse de croissance, par exemple en changeant les débits des gaz porteurs. La vitesse de croissance est variable. Dans le cas de la figure 3, elle était de 90 µm par heure car les flux de gaz porteur étaient de 0,5 litre par minute dans les deux lignes d'organométalliques et d'hydrure.

Ensuite, on a interrompu le flux de silane et l'on a laissé la croissance des fils se poursuivre pendant un temps variable T, allant de 0 à 800 secondes, d'où une longueur totale variable L(T) pour les fils. Puis on a fait croître des multipuits quantiques (en anglais, *multiquantum wells*) sur une longueur l(T) de la zone des fils qui n'est pas recouverte par le nitrure de silicium.

Les variations de l(T) en fonction de L(T) sont représentées sur la figure 3.

On constate que les points obtenus se répartissent sensiblement le long d'une droite D. Cette dernière coupe l'axe des abscisses en H.

Cela confirme que les multipuits quantiques ne se forment pas sur le nitrure de silicium.

Les figures 4A et 4B sont des vues de dessus schématiques de structures qui sont obtenues par un procédé conforme à l'invention et résultent respectivement des structures représentées sur les figures 2A et 2B.

De façon connue, des fils, du genre de ceux qui sont représentés sur la figure 2A ou 2B, peuvent être détachés de leur substrat en grattant ce dernier ou en exposant à des ultrasons l'ensemble fils-substrat plongé dans une solution d'éthanol ; et ces fils peuvent ensuite être posés sur un autre substrat.

On applique alors un tel traitement à l'ensemble vertical fil 12-diélectrique 14 (respectivement fil 12-diélectrique 14-couche ou multicouche 16) que l'on voit sur la figure 2A (respectivement 2B) pour le détacher de son substrat 6 ; puis on le dépose sur un autre substrat 18 qui est par exemple électriquement isolant. On obtient ainsi la structure qui est représentée sur la figure 4A (respectivement 4B) et qui repose horizontalement sur le substrat 18.

On peut ensuite former, par exemple déposer, trois contacts métalliques ou ohmiques 20, 22, 24 sur la structure, comme on le voit sur les figures 4A et 4B.

Dans l'exemple représenté sur la figure 4A (respectivement 4B), les contacts 22 et 24 sont formés sur la couche diélectrique 14 et le contact 20 est formé sur la partie du fil 12 ne comportant pas de diélectrique (respectivement sur la couche ou multicouche 16).

Il convient de noter que le contact 24 peut être directement formé sur le fil semiconducteur 12 si l'on enlève ou si l'on détruit localement le diélectrique 14 avant de former le contact 24. Ce contact 24 peut servir de source dans un dispositif nanoélectronique ; tandis que le contact 20 peut servir de drain et le contact 22 de grille (en anglais, *gate*)*.*

La figure 5 est une vue en coupe schématique d'un dispositif que l'on a obtenu conformément à l'invention. Ce dispositif comprend une multicouche qui constitue une hétérostructure et a été ajoutée au fil semiconducteur comme on l'a déjà expliqué plus haut.

Ce dispositif est identique à la structure qui a été décrite en faisant référence à la figure 2B, à ceci près que l'on a formé en outre :
- une couche métallique 26, constituant un premier contact sur la face du substrat 6, opposée à celle qui porte la couche 8,
- une couche électriquement isolante 28 sur cette couche 8, et
- une autre couche métallique 30 formant un deuxième contact sur la couche 28.

Plus précisément, la couche 28 s'étend jusqu'à un certain niveau de la multicouche 16 (hétérostructure), et la couche 30 s'étend sur une partie périphérique de cette dernière, comme on le voit. Et, dans cet exemple, le substrat 6 est électriquement conducteur ou semiconducteur.

La figure 5 illustre l'intérêt que présente le procédé, objet de l'invention, pour résoudre des problèmes de tolérance aux alignements.

En effet, dans le dispositif représenté sur cette figure 5, la couche isolante 28 peut être une couche de résine (en anglais, *resist*) présentant des défauts : son épaisseur n'est pas nécessairement ajustée aux hauteurs respectives de la couche 14 et de la multicouche 16 ; donc, si la couche diélectrique 14 n'était plus présente, la couche 30 risquerait d'être en contact avec le support constitué par le fil semiconducteur 12.

Suivant la nature de l'hétérostructure, le dispositif représenté sur la figure 5 peut correspondre à une diode photo-émettrice ou à une diode photodétectrice. Sa fabrication ne nécessite que très peu d'étapes technologiques du fait de la croissance spontanée de la couche diélectrique 14.

A propos de la figure 5, on précise que la couche 30 y est représentée comme plane et ne recouvrant pas la multicouche 16. Mais, en général, tous les cas sont possibles (et observables) et l'on peut avoir un recouvrement total de la multicouche 16 par la couche 30 ou, au contraire, un dépôt quasiment conforme (et d'épaisseur presque constante) autour de la multicouche 16.

La couche 30 peut aussi être conforme, au sommet de la multicouche 16.

Ceci est schématiquement illustré par la figure 6. On y voit la structure de la figure 2B sur laquelle une couche supplémentaire 32 a été déposée de façon standard. Cette couche 32 sert d'électrode pour constituer par exemple une diode électroluminescente et elle est faite d'un matériau électriquement conducteur et transparent, par exemple un TCO (oxyde transparent conducteur) tel qu'un ITO (oxyde d'indium dopé étain). On voit aussi que la structure de la figure 6 comprend la couche métallique 26 sur le substrat 6, comme dans le cas de la figure 5.

La couche 32 recouvre entièrement et de façon conforme la structure, en particulier les couches 16 et 14. Plus précisément, le recouvrement de la couche 16 (multicouche) permet d'améliorer l'injection des charges électriques ; et grâce à la présence de la couche isolante 14, la couche 32 peut descendre jusqu'au substrat qui est isolé par la couche de masquage 8. On évite ainsi tout couplage de la lumière, émise par la multicouche 16, par les flancs latéraux de cette dernière et l'on améliore de ce fait l'extraction globale du dispositif global.

En outre, on précise que le contact métallique correspondant à la couche 26 peut aussi se faire du même côté du substrat 6 que la structure formée sur celui-ci, en ajoutant des étapes de lithographiegravure pour assurer la continuité entre le métal et le substrat 6. De plus, le substrat 6 peut éventuellement être constitué d'un isolant (par exemple du saphir) recouvert de GaN avec au moins une couche très dopée au contact du fil 12.

Dans les exemples de l'invention, on a interrompu la croissance de la couche diélectrique. Mais cette croissance pourrait être reprise après l'interruption, en envoyant à nouveau le ou les flux appropriés dans l'enceinte dans laquelle on forme les structures.

## Revendications

1. Procédé de croissance sélective MOCVD sans catalyseur d'une première structure semi-conductrice (12) formant un fil de GaN, dans lequel :
- on forme à partir de premiers flux gazeux ou moléculaires comprenant les précurseurs TMG, triméthylgallium, pour le gallium et NH₃ pour
l'azote la première structure semi-conductrice (12) au niveau d'une ouverture (10) d'une couche de masquage (8) recouvrant un substrat (6),
le procédé étant **caractérisé en ce que** :
- en même temps on ajoute, aux premiers flux gazeux ou moléculaires, du silane, SiH₄,
un flux du silane étant choisi pour faire croître sélectivement et in situ et pendant la croissance de la partie inférieure de la première structure (12) une couche diélectrique latérale de passivation en SiNx (14) sur la première structure semi-conductrice (12) et pour induire un dopage de type N dans ladite première structure,
- ensuite on arrête le flux de silane afin de laisser continuer la croissance de la première structure (12) sans formation de la couche diélectrique de passivation en SiNx (14),
- ensuite, sur la première structure semiconductrice (12) pourvue, sur une partie, de la couche diélectrique (14), on fait croître une deuxième structure semi-conductrice (16) à partir de troisièmes flux gazeux ou moléculaires, la croissance de la deuxième structure ayant lieu uniquement sur la partie du support dépourvue de la couche diélectrique de passivation (14).

2. Procédé selon la revendication 1, dans lequel on choisit les conditions de croissance de la couche diélectrique (14) de façon à agir sur la formation de la première structure semi-conductrice (12).

3. Procédé selon l'une des revendications 1 où 2, dans lequel on interrompt la croissance de la couche diélectrique (14), puis on la reprend.

4. Procédé selon l'une quelconque des revendications précédentes , dans lequel la première structure semi-conductrice est un fil (12) qui s'étend verticalement à partir du substrat (6), on fait croître la couche diélectrique (14) de façon qu'elle recouvre une partie inférieure du fil (12) à partir du substrat (6), et l'on fait croître la deuxième structure semi-conductrice (16) seulement sur une partie supérieure du fil (12), qui n'est pas recouverte par la couche diélectrique (14).

5. Procédé selon la revendication 4, dans lequel on utilise un substrat (6) électriquement conducteur ou semiconducteur, on forme les première et deuxième structures semiconductrices (12, 16) de façon à constituer une diode, et l'on forme en outre un premier contact électriquement conducteur (26) sur le substrat et un deuxième contact électriquement conducteur (30) sur la deuxième structure semi-conductrice (16) .

6. Procédé selon la revendication 4, dans lequel on utilise un substrat (6) électriquement conducteur ou semiconducteur, on forme les première et deuxième structures semiconductrices (12, 16) de façon à constituer une diode, et l'on forme en outre un premier contact électriquement conducteur (26) sur le substrat et une couche en matériau électriquement conducteur et transparent (32) qui recouvre de façon conforme la couche diélectrique (14) et la deuxième structure semiconductrice (16).

7. Procédé selon la revendication 4, dans lequel on sépare le fil (12) du substrat (6) après avoir formé la deuxième structure semi-conductrice (16), puis on place le fil sur un autre substrat (18) de façon que le fil s'étende horizontalement sur l'autre substrat.

8. Procédé selon la revendication 7, dans lequel on forme en outre des contacts ohmiques ou électriquement conducteurs (20, 22, 24) sur le fil, au niveau de la couche diélectrique (14) et de la deuxième structure semi-conductrice (16) .

## Patentansprüche

1. Verfahren zum katalysatorfreien selektiven MOCVD-Aufwachsen einer ersten Halbleiterstruktur (12), die einen GaN-Draht bildet, bei dem:
- man ausgehend von ersten gasförmigen oder molekularen Flüssen, die TMG-, Trimethylgallium-, Präkursoren für das Gallium und NH₃ für den Stickstoff umfassen, die erste Halbleiterstruktur (12) im Bereich einer Öffnung (10) einer Maskierungsschicht (8) bildet, die ein Substrat (6) bedeckt,
wobei das Verfahren **dadurch gekennzeichnet ist, dass**:
- man gleichzeitig zu den ersten gasförmigen oder molekularen Flüssen Silan, SiH₄, hinzufügt,
wobei ein Silanfluss dazu ausgewählt wird, selektiv und in situ und während des Wachsens des unteren Teils der ersten Struktur (12) eine dielektrische laterale Passivierungsschicht aus SiNx (14) auf der ersten Halbleiterstruktur (12) wachsen zu lassen, und eine Dotierung von Typ N in der ersten Struktur zu induzieren,
- man anschließend den Silanfluss stoppt, um das Wachstum der ersten Struktur (12) ohne Bildung der dielektrischen Passivierungsschicht aus SiNx (14) fortlaufen zu lassen,
- man anschließend auf der ersten Halbleiterstruktur (12), die auf einem Teil mit der dielektrischen Schicht (14) versehen ist, eine zweite Halbleiterstruktur (16) ausgehend von dritten gasförmigen oder molekularen Flüssen wachsen lässt, wobei das Wachstum der zweiten Struktur ausschließlich auf dem Teil des Trägers erfolgt, der nicht mit der dielektrischen Passivierungsschicht (14) versehen ist.

2. Verfahren nach Anspruch 1, bei dem man die Wachstumsbedingungen der dielektrischen Schicht (14) derart wählt, dass auf die Bildung der ersten Halbleiterstruktur (12) eingewirkt wird.

3. Verfahren nach einem der Ansprüche 1 oder 2, bei dem man das Wachstum der dielektrischen Schicht (14) unterbricht, und dann wiederaufnimmt.

4. Verfahren nach einem der vorhergehenden Ansprüche, bei dem die erste Halbleiterstruktur ein Draht (12) ist, der sich vertikal ausgehend von dem Substrat (6) erstreckt, wobei man die dielektrische Schicht (14) derart wachsen lässt, dass sie einen unteren Teil des Drahts (12) ausgehend von dem Substrat (6) bedeckt, und wobei man die zweite Halbleiterstruktur (16) ausschließlich auf einem oberen Teil des Drahts (12) wachsen lässt, der nicht durch die dielektrische Schicht (14) bedeckt ist.

5. Verfahren nach Anspruch 4, bei dem man ein elektrisch leitendes oder ein Halbleitersubstrat (6) verwendet, wobei man die erste und die zweite Halbleiterstruktur (12, 16) derart bildet, dass sie eine Diode bilden, und man ferner einen ersten elektrisch leitenden Kontakt (26) auf dem Substrat und einen zweiten elektrisch leitenden Kontakt (30) auf der zweiten Halbleiterstruktur (16) bildet.

6. Verfahren nach Anspruch 4, bei dem man ein elektrisch leitendes oder ein Halbleitersubstrat (6) verwendet, wobei man die erste und die zweite Halbleiterstruktur (12, 16) derart bildet, dass sie eine Diode bilden, und man ferner einen ersten elektrisch leitenden Kontakt (26) auf dem Substrat und eine Schicht aus einem elektrisch leitenden und transparenten Material (32) bildet, die die dielektrische Schicht (14) und die zweite Halbleiterstruktur (16) auf konforme Weise bedeckt.

7. Verfahren nach Anspruch 4, bei dem man den Draht (12) von dem Substrat (6) separiert, nachdem man die zweite Halbleiterstruktur (16) gebildet hat, und man dann den Draht auf einem anderen Substrat (18) derart platziert, dass sich der Draht horizontal auf dem anderen Substrat erstreckt.

8. Verfahren nach Anspruch 7, bei dem man ferner Ohm'sche oder elektrisch leitende Kontakte (20, 22, 24) auf dem Draht im Bereich der dielektrischen Schicht (14) und der zweiten Halbleiterstruktur (16) bildet.

## Claims

1. A method for selectively growing by MOCVD without catalyst a first semi-conducting structure (12) forming a GaN wire, wherein:
- from first gas or molecular flows comprising the TMG precursors, trimethylgallium, for gallium and NH₃ for nitrogen, the first semi-conducting structure (12) is formed at an aperture (10) of a masking layer (8) covering a substrate (6),
the method being **characterised in that**:
- at the same time, silane, SiH₄, is added to the first gas or molecular flows,
a silane flow being selected to selectively grow *in situ* and upon growing the lower part of the first structure (12) a lateral SiNx passivation dielectric layer (14) on the first semi-conducting structure (12) and to induce N-type doping in said first structure,
- and then the silane flow is stopped in order to let the first structure (12) to continue growing without forming the SiNx passivation dielectric layer (14),
- and then, on the first semi-conducting structure (12) provided, on one part, with the dielectric layer (14), a second semi-conducting structure (16) is grown from third gas or molecular flows, growing the second structure only occurring on the part of the support devoid of the passivation dielectric layer (14).

2. The method according to claim 1, wherein the conditions for growing the dielectric layer (14) are selected so as to act on the formation of the first semi-conducting structure (12).

3. The method according to one of claims 1 or 2, wherein growing the dielectric layer (14) is interrupted, and then resumed.

4. The method according to any of the preceding claims, wherein the first semi-conducting structure is a wire (12) extending vertically from the substrate (6), a dielectric layer (14) is grown so as to cover a lower part of the wire (12) from the substrate (6), and the second semi-conducting structure (16) is grown only on an upper part of the wire (12), which is not covered with the dielectric layer (14).

5. The method according to claim 4, wherein an electrically conducting or semi-conducting substrate (6) is used, the first and second semi-conducting structures (12, 16) are formed so as to make up a diode, and they are further formed a first electrically conducting contact (26) on the substrate (6) and a second electrically conducting contact (30) on the second semi-conducting structure (16).

6. The method according to claim 4, wherein an electrically conducting or semi-conducting substrate (6) is used, the first and second semi-conducting structures (12, 16) are formed so as to make up a diode, and they are further formed a first electrically conducting contact (26) on the substrate and a transparent electrically conducting material layer (32) which conformably covers the dielectric layer (14) and the second semi-conducting structure (16).

7. The method according to claim 4, wherein the wire (12) is separated from the substrate (6) after the second semi-conducting structure (16) has been formed, and then the wire is placed on another substrate (18) so that the wire extends horizontally over the other substrate.

8. The method according to claim 7, wherein ohmic or electrically conducting contacts (20, 22, 24) are further formed on the wire, at the dielectric layer (14) or at the second semi-conducting structure (16).
